# FASCICULE DE BREVET EUROPEEN

(11) **EP 3 411 941 B1**
(45) Date de publication et mention de la délivrance du brevet: **22.01.2020**
(21) Numéro de dépôt: 17707366.5
(22) Date de dépôt: 24.01.2017
(51) Int. Cl.: H02K 5/20, H02K 9/19

(54) **DISPOSITIF DE REFROIDISSEMENT POUR UNE MACHINE ÉLECTRIQUE**
KÜHLVORRICHTUNG FÜR EINE ELEKTRISCHE MASCHINE
COOLING DEVICE FOR AN ELECTRICAL MACHINE

(30) Priorité: 03.02.2016 FR 1650860
(43) Date de publication de la demande: 12.12.2018
(73) Titulaire: RENAULT s.a.s., 92100 Boulogne-Billancourt (FR); Nissan Motor Co., Ltd., Yokohama-shi, Kanagawa 221-0023 (JP)
(72) Inventeur: DECAUX, Stephane, 76000 Rouen (FR); TAVERNIER, Guillaume, 27330 La Barre en Ouche (FR); PARIS, Francois, 76920 Amfreville La Mivoie (FR)
(74) Mandataire: Rougemont, Bernard
(86) Numéro de dépôt international: PCT/FR2017/050142
(87) Numéro de publication internationale: WO 2017/134364

(56) Documents cités:
- CN-A- 103 532 307
- CN-U- 203 645 474
- DE-A1-102012 019 749
- DE-T5-112012 000 077
- DE-T5-112012 003 425
- FR-A1- 2 712 238
- JP-A- 2004 180 479
- JP-A- 2013 198 311
- JP-B1- S4 828 842

## Description

La présente invention se rapporte à un dispositif de refroidissement pour une machine électrique montée dans un ensemble mobile.

En particulier, dans le domaine de l'électrotechnique, on connait différentes méthodes pour refroidir une machine électrique.

On connait notamment les techniques de refroidissement à l'eau qui consistent généralement à faire circuler dans la machine, au voisinage des bobinages statoriques, un circuit d'eau isolé, afin de ne pas mettre en contact l'eau avec les composants électriques de la machine. On connait aussi le refroidissement à air qui consiste à forcer le passage d'air frais dans la machine. Enfin, on connait le refroidissement à huile, et plus généralement par tout liquide diélectrique caloporteur. Le refroidissement à huile présente plusieurs avantages : l'huile ne pose pas de problème d'isolation électrique, et ne nécessite pas d'installation volumineuse comme le refroidissement à air.

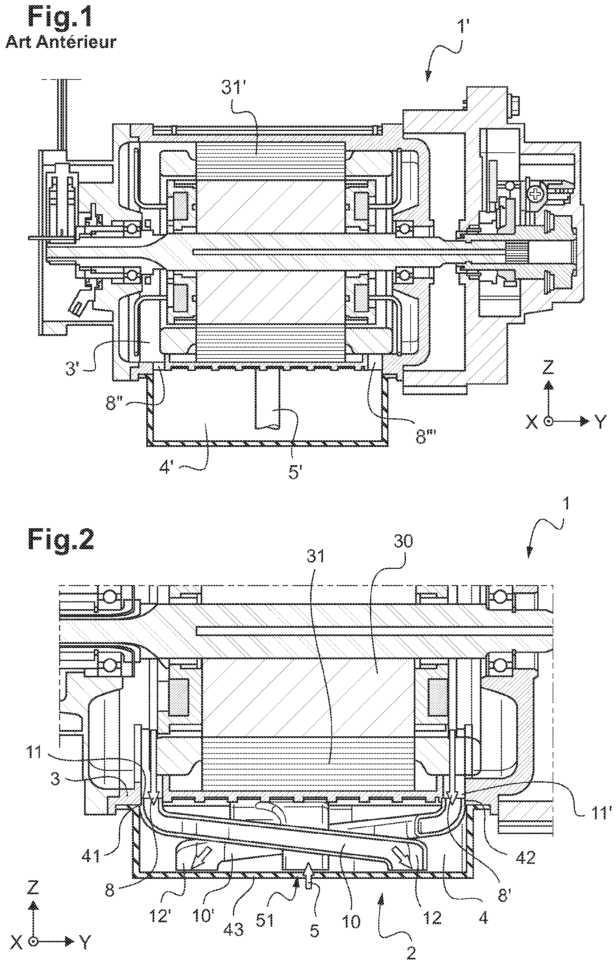

On connait en particulier, en référence à la figure 1 d'art antérieur, un refroidissement à huile consistant à pulvériser de l'huile directement dans le carter 3' de la machine électrique 1', en général au niveau des chignons du stator 31'. L'huile s'écoule par gravité au fond du carter 3', où elle traverse des orifices 8",8'" débouchant sur un réservoir à huile 4'. Une pompe, non représentée récupère l'huile dans ce réservoir 4', via une buse d'aspiration 5', pour le réinjecter après refroidissement au niveau des chignons du stator 31'.

Une telle machine électrique est divulguée dans le document CN 203645474 U.

Cependant, lorsqu'une telle machine est montée dans un ensemble mobile, par exemple dans un véhicule automobile, les accélérations longitudinales et latérales auxquelles est soumise la machine, déplacent l'huile dans le réservoir à huile, de sorte qu'il arrive que la buse d'aspiration se trouve à l'air, on parle alors de déjaugeage. Ceci peut conduire à la pénétration d'air dans la pompe et peut provoquer un désamorçage de la pompe. En conséquence ci pose un problème de fiabilité du refroidissement du moteur.

Aussi, il existe le besoin d'un dispositif de refroidissement à huile d'une machine électrique pouvant fonctionner de manière fiable lorsque la machine est montée dans un ensemble mobile.

On propose un dispositif de refroidissement d'une machine électrique destiné à être monté dans un ensemble mobile, ledit dispositif de refroidissement comprenant :
- un carter pour recevoir ladite machine électrique,
- un réservoir de liquide diélectrique caloporteur présentant un fond et deux extrémités opposées, ledit réservoir étant monté à l'aplomb dudit carter, tandis que ledit carter présente au moins un orifice d'évacuation du liquide diélectrique débouchant dans ledit réservoir ;
- des moyens de circulation du liquide diélectrique caloporteur pour venir aspirer le liquide diélectrique caloporteur dans ledit fond dudit réservoir et pour projeter ledit liquide diélectrique caloporteur sur ladite machine électrique, tandis que ledit liquide diélectrique caloporteur s'écoule à travers ledit orifice d'évacuation ; ledit orifice d'évacuation débouchant à une extrémité du réservoir.

Le dispositif de refroidissement comprend en outre un conduit d'évacuation du liquide diélectrique caloporteur s'étendant dans ledit réservoir, dudit orifice d'évacuation vers l'autre extrémité du réservoir.

Ainsi, lorsqu'une accélération latérale est appliquée à l'ensemble mobile, par exemple un virage à gauche ou à droite pour un véhicule automobile, si le liquide diélectrique caloporteur est dirigé du côté de l'orifice, le conduit d'évacuation interdit au liquide diélectrique caloporteur de remonter dans le carter par l'orifice.

Avantageusement et de manière non limitative, ladite buse d'aspiration est disposée sensiblement à équidistance desdites extrémités opposées dudit réservoir.

En particulier, l'ouverture de la buse d'aspiration peut être disposée sensiblement au voisinage du fond du réservoir. Ainsi, on améliore l'aspiration du liquide diélectrique caloporteur dans le réservoir lorsque le liquide est en mouvement dans le réservoir.

Avantageusement et de manière non limitative, ledit conduit d'évacuation présente une première extrémité et une deuxième extrémité éloignées l'une de l'autre d'une distance supérieure à la distance entre l'orifice d'évacuation et la buse d'aspiration.

Ainsi, on interdit de manière plus efficace au liquide diélectrique caloporteur de remonter dans le conduit lors d'une accélération accumulant le liquide diélectrique caloporteur vers l'orifice d'évacuation et donc on permet au réservoir de contenir toujours assez de liquide diélectrique caloporteur pour maintenir la buse dans le liquide diélectrique caloporteur, même lorsque le liquide diélectrique caloporteur est déplacé dans le réservoir.

En particulier, lorsque l'effet d'aspiration du liquide diélectrique caloporteur de la buse d'aspiration est produit par une pompe, on assure ainsi que la buse d'aspiration est toujours dans le liquide diélectrique caloporteur afin de ne pas risquer de désamorcer la pompe. De cette manière on améliore la fiabilité du fonctionnement du système de refroidissement de la machine électrique, même lorsque le système mobile subit des accélérations.

Avantageusement et de manière non limitative, ladite première extrémité du conduit d'évacuation forme une jonction étanche avec ledit orifice.

Ainsi, le liquide diélectrique caloporteur s'écoulant au travers de l'orifice s'écoule ensuite nécessairement dans le conduit, ce qui évite un écoulement non maitrisé du liquide depuis l'orifice dans le réservoir, et évite la remontée de liquide du réservoir dans le carter lors d'accélération déplaçant le liquide diélectrique caloporteur dans le réservoir.

Avantageusement et de manière non limitative, ladite deuxième extrémité du conduit d'évacuation est disposée au voisinage de ladite autre extrémité du réservoir. Ainsi, on interdit de manière plus efficace au liquide diélectrique caloporteur de remonter dans le conduit d'évacuation lors d'une accélération accumulant le liquide diélectrique caloporteur vers l'orifice d'évacuation.

Avantageusement et de manière non limitative, ledit conduit d'évacuation s'étend de manière oblique entre sa première et sa deuxième extrémité. Ainsi on facilite l'écoulement du liquide diélectrique dans le conduit d'évacuation.

En particulier, la deuxième extrémité du conduit peut déboucher au voisinage du fond du réservoir.

Avantageusement et de manière non limitative, ledit orifice s'étend sensiblement sur toute la longueur de l'extrémité du réservoir, c'est-à-dire sur tout un bord latéral de celui-ci. Ainsi, on améliore les capacités d'évacuation du liquide diélectrique caloporteur du carter vers le réservoir.

Avantageusement et de manière non limitative, ledit conduit d'évacuation est clipsé à ladite paroi du carter. Ainsi, on peut obtenir un conduit d'évacuation relativement simple à fixer au carter.

Avantageusement et de manière non limitative, le dispositif de refroidissement comprend deux orifices débouchant chacun à une extrémité opposée distincte dudit réservoir, le dispositif comprend deux conduits solidaires chacun d'un orifice distinct, lesdits conduits s'étendant chacun depuis ledit orifice distinct vers l'extrémité du réservoir à l'opposé dudit orifice distinct. Ainsi, on peut refroidir efficacement les deux extrémités du stator de la machine électrique, en formant sur le carter en aval de chacune des extrémités du stator, un orifice et en installant un conduit d'évacuation associé.

Avantageusement et de manière non limitative, le liquide diélectrique caloporteur peut comprendre de l'huile.

L'invention concerne aussi un véhicule automobile comprenant un dispositif de refroidissement tel que décrit précédemment.

D'autres particularités et avantages de l'invention ressortiront à la lecture de la description faite ci-après d'un mode de réalisation particulier de l'invention, donné à titre indicatif mais non limitatif, en référence aux dessins annexés sur lesquels :
- la figure 1, est une représentation d'un dispositif de refroidissement d'une machine électrique de l'art antérieur ;
- la figure 2 est une vue en coupe d'un dispositif de refroidissement selon un mode préféré de réalisation de l'invention ;
- la figure 3 est une vue en perspective d'un dispositif de refroidissement selon le mode de réalisation de la figure 2, en absence du réservoir pour une meilleure visibilité; et
- la figure 4 est une vue en perspective d'un dispositif de refroidissement selon le mode de réalisation de la figure 2 et de la machine électrique, dans laquelle le réservoir est partiellement représenté.

Dans la présente description, les termes avant, arrière, supérieur, inférieur, font référence aux directions avant et arrière du véhicule, lorsque le dispositif de refroidissement 2 et la machine électrique 1 sont montés sur le véhicule. Les axes X, Y, Z correspondent respectivement à l'axe longitudinal (d'avant en arrière), transversal et vertical du véhicule.

Par sensiblement horizontal, longitudinal ou vertical, on entend une direction/un plan formant un angle d'au plus ±20°, voire d'au plus 10° ou d'au plus 5°avec une direction/un plan horizontal, longitudinal ou vertical.

Par sensiblement parallèle, perpendiculaire ou à angle droit, on entend une direction/un angle s'écartant d'au plus ±20°, voire d'au plus 10° ou d'au plus 5° d'une direction parallèle, perpendiculaire ou d'un angle droit.

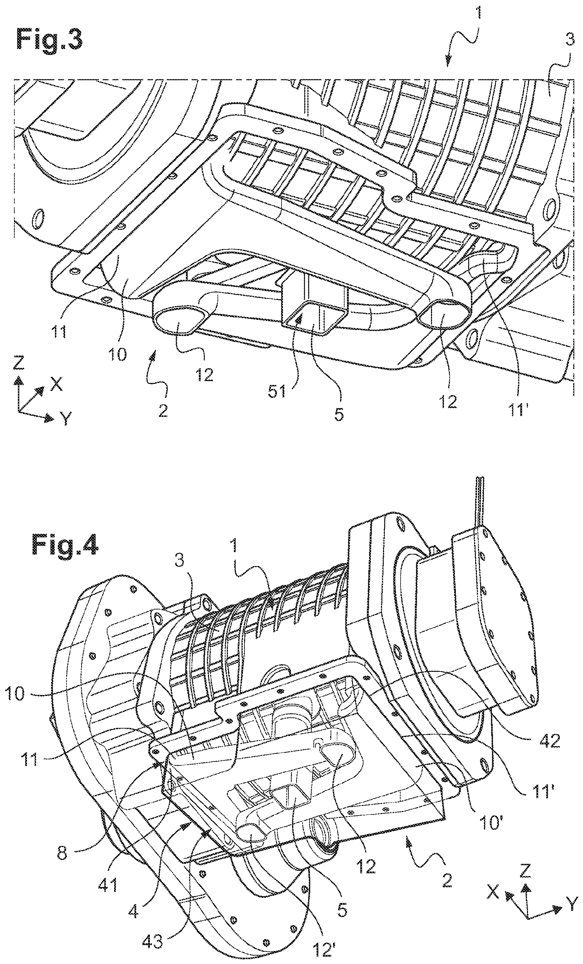

Les figures 2 à 4 se rapportant à un même mode de réalisation de l'invention, elles seront commentées simultanément.

Une machine électrique 1 est installée dans un ensemble mobile, ici un véhicule automobile.

La machine électrique 1 comprend un stator 31 et un rotor 30 et est installée dans un carter 3 l'isolant des autres composants du véhicule automobile.

Le carter 3 forme une enveloppe imperméable aux liquides autour de la machine électrique 1.

Le rotor 30 est inséré dans le stator 31 et est entrainé en rotation autour d'un axe de rotation par un champ électromagnétique produit par le stator 31.

La machine électrique 1 est orientée dans le véhicule automobile de telle sorte que l'axe de rotation du rotor 30 est colinéaire à la direction transversale du véhicule automobile. Cependant, l'invention peut être adaptée pour toute autre orientation de la machine électrique 1 dans le véhicule automobile.

Ainsi, la machine électrique 1 est orientée de sorte qu'elle s'étend dans sa longueur selon l'axe transversal du véhicule automobile.

Lorsque le véhicule automobile est en position d'arrêt, sur une surface horizontale, l'axe de rotation du rotor 30 s'étend, en outre, dans un plan sensiblement horizontal.

Un dispositif de refroidissement 2 pour refroidir la machine électrique 1 est aussi installé dans le véhicule automobile.

Le dispositif de refroidissement 2 fonctionne par échange thermique avec un liquide diélectrique caloporteur, ici de l'huile.

Dans la suite de la description, il sera fait référence au liquide diélectrique caloporteur comme étant de l'huile. Cependant, tout autre liquide diélectrique caloporteur peut être utilisé.

Le dispositif de refroidissement 2 comprend un réservoir 4 d'huile et des moyens de circulation de l'huile.

Le réservoir 4 est solidarisé de manière étanche au carter 3, en aval du carter 3.

Ainsi, le réservoir 4 est installé sous la machine électrique 1 et le carter 3 forme le couvercle du réservoir 4.

Le réservoir 4 présente une forme sensiblement en parallélépipède rectangle, dont la longueur principale est sensiblement colinéaire avec l'axe de rotation du rotor 30 de la machine électrique 1.

Aussi, le réservoir 4 s'étend sensiblement en longueur parallèlement à la longueur de la machine électrique 1, ici dans la direction transversale du véhicule automobile.

En particulier, le réservoir 4 présente une longueur sensiblement supérieure à la longueur du stator 31.

Ici, la longueur du réservoir 4 est au plus égale à la longueur du carter 3. En effet, le réservoir 4 peut présenter une longueur supérieure à la longueur du carter 3, mais ceci produirait une augmentation de l'encombrement général de l'ensemble formé par la machine électrique 1 et le dispositif de refroidissement 2 qui n'est pas souhaitable.

La largeur du réservoir 4 s'étend selon l'axe longitudinal du véhicule automobile.

Le réservoir 4 présente une largeur sensiblement égale à la valeur du diamètre du stator 31 de la machine électrique 1.

Le réservoir 4 présente une valeur de profondeur inférieure aux valeurs de longueur et de largeur.

En effet, le réservoir 4 est installé sous le carter 3, or il est fréquent pour les machines électriques 1 de traction d'un véhicule automobile, que cette machine 1 soit installée dans la partie arrière du véhicule automobile, sous le plancher. Par conséquent, afin de se conformer aux exigences de garde au sol du véhicule automobile, la profondeur du réservoir 4 est relativement faible par rapport à ses dimensions de longueur et de largeur.

Les moyens de circulation de l'huile comprennent une buse d'aspiration 5 adaptée pour aspirer l'huile du réservoir 4 sous l'effet d'une pompe, non représentée, qui achemine l'huile jusqu'à un élément de projection adapté pour projeter l'huile dans le carter 3.

Ici, l'élément de projection comprend pour chaque extrémité longitudinale du stator 30, une buse de projection installée dans le carter 3 en regard du chignon statorique.

Le chignon d'un stator est l'ensemble des parties des enroulements visibles à chaque extrémité longitudinale du stator ; parties visibles que l'on appelle aussi les têtes de bobines. Or, une importante proportion de l'échauffement du stator 31 lors du fonctionnement de la machine électrique 1 est produite au niveau des chignons. C'est pourquoi nous projetons l'huile directement sur ces chignons.

L'huile pompée par la buse d'aspiration 5 dans le réservoir 4 est acheminée, sous l'effet de la pompe, jusqu'aux buses de projection qui projettent l'huile sur les chignons statoriques.

Au contact des chignons statoriques, l'huile s'échauffe par échange thermique, ce qui a pour effet de refroidir les chignons statoriques.

L'huile projetée s'écoule ensuite par gravité jusqu'au fond du carter 3.

La majorité de l'huile projetée sur les chignons statoriques ne pénètre pas dans la machine électrique, mais s'écoule par gravité le long des parois d'extrémités longitudinales du stator. Autrement dit, l'huile ne pénètre ni l'entrefer, ni les encoches statoriques. Ainsi, l'huile s'écoule par gravité de chaque côté du stator.

Un orifice d'évacuation 8,8' est ménagé, pour chaque extrémité longitudinale du stator 31, dans la paroi de fond du carter 3, sensiblement en aval de l'extrémité longitudinale associée. L'orifice débouche d'une part dans le réservoir 4 et d'autre part dans le carter 3.

L'huile projetée dans le carter 3 au niveau du chignon statorique d'une extrémité du stator s'écoule dans le fond du carter 3, traverse les orifices d'évacuation 8,8' et s'accumule dans le réservoir 4.

De par le fait que la longueur du réservoir 4 est sensiblement égale à la longueur du stator 31, les orifices d'évacuation 8,8' s'étendent chacun respectivement au voisinage d'un bord latéral 41,42 du réservoir 4.

On fera aussi référence aux bords latéraux 41,42 du réservoir 4 sous l'appellation d'extrémités opposées 41,42 du réservoir 4.

Ainsi, un premier bord latéral 41,42 correspond à une extrémité 41,42 du réservoir 4 qui est opposée à une autre extrémité 42,41 du réservoir 4, correspondant au deuxième bord latéral 42,41.

Afin d'assurer une bonne évacuation de l'huile du carter 3 vers le réservoir 4, les orifices 8,8' s'étendent sensiblement sur une longueur du carter 3 correspondant sensiblement à la largeur du réservoir 4.

Aussi, l'orifice d'évacuation 8,8' débouche dans le réservoir 4, au voisinage d'un bord latéral 41,42, sensiblement sur toute la longueur de ce bord 41,42.

Cependant, les orifices 8,8' peuvent s'étendre sur tout ou partie de la largeur du réservoir.

La buse d'aspiration 5 est installée dans le réservoir 4 de manière à pouvoir aspirer l'huile accumulée. En particulier la buse d'aspiration 5 est disposée sensiblement au milieu du réservoir 4.

L'ouverture 51 de la buse 5 est orientée vers le fond 43 du réservoir 4, de manière à favoriser son immersion dans l'huile.

L'ouverture 51 de la buse d'aspiration 5 est rapprochée du fond 43 du réservoir 4 de manière à maximiser l'immersion de la buse 5 dans l'huile tout en assurant un bon écoulement de l'huile entre le fond 43 du réservoir 4 et la buse d'aspiration 5. En effet, sous l'effet de la pompe, la buse d'aspiration 5 aspire l'huile du réservoir 4, et si l'ouverture 51 de la buse d'aspiration 5 est hors de l'huile, la pompe risque d'être désamorcée.

Afin d'éviter que l'ouverture 51 de la buse d'aspiration 5 puisse se retrouver hors de l'huile, on souhaite s'assurer qu'une quantité minimale d'huile soit toujours présente dans le réservoir 4.

Or, lors des accélérations transversales du véhicule automobile, et compte tenu de la disposition des orifices 8,8' d'évacuation du carter 3, l'effet centrifuge provoque une accumulation de l'huile du côté du réservoir 4 opposé à la direction de virage du véhicule automobile. Cette accumulation d'huile provoque une remontée de l'huile au travers d'un orifice d'évacuation 8,8'. Comme l'huile remonte dans le carter 3, la quantité d'huile présente dans le réservoir 4 diminue et l'ouverture 51 de la buse d'aspiration 5 peut se retrouver hors de l'huile.

Afin de résoudre ce problème, on installe pour chaque orifice d'évacuation 8,8' un conduit d'évacuation 10,10'.

Chaque conduit d'évacuation 10,10' s'étend dans le réservoir 4, entre une première extrémité 11,11 ', et une deuxième extrémité 12,12'.

La première extrémité 11,11' du conduit d'évacuation 10,10' forme une jonction étanche avec un orifice 8,8' associé.

Les conduits d'évacuation 10,10' sont clipsés soit à un bord latéral 41,42 du réservoir 4, soit à un bord longitudinal du réservoir 4, ou bien au carter 3 ou encore à plusieurs de ces points d'attache.

Les conduits d'évacuation 10,10' peuvent aussi être solidarisés par collage, soudage, vissage ou tout autre moyen de fixation adapté.

Dans la suite de la description, nous décrivons les deux conduits 10,10' indistinctement l'un de l'autre, les deux conduits 10,10' étant sensiblement identiques dans leur structure propre, ce qui facilite et réduit les coûts de production à grande échelle de tels conduits 10,10'.

A des fins de concision de la description, lorsqu'on se réfère au conduit 10,10', sans plus de précision, il convient de comprendre que ceci s'applique pour chaque conduit d'évacuation 10, 10' associé à un orifice 8, 8'.

La deuxième extrémité 12,12' du conduit 10,10' débouche dans le réservoir de manière à permettre à l'huile s'écoulant au travers de l'orifice 8,8' de s'écouler dans le conduit d'évacuation 10,10' depuis la première extrémité 11,11' jusqu'à la deuxième extrémité 12,12', et de s'accumuler dans le réservoir 4.

Le conduit d'évacuation 10,10' s'étend donc depuis un bord latéral 41,42, correspondant au bord latéral 41,42 au voisinage duquel débouche l'orifice 8,8' associé, et le conduit d'évacuation 10,10' s'étend dans le réservoir 4 en direction du bord latéral 41,42 opposé, par exemple au voisinage du bord latéral 41,42 opposé.

Ainsi, les deux conduits d'évacuation 10,10' associés chacun à un orifice 8,8' se croisent dans le réservoir 4. De cette manière, la première extrémité 11 d'un premier conduit d'évacuation 10 est disposé, dans la longueur du réservoir 4, à proximité de la deuxième extrémité 12' de l'autre conduit d'évacuation 10', et réciproquement.

Aussi, le conduit d'évacuation 10,10' est conformé de manière à ce que la distance entre la première extrémité 11,11' et la deuxième extrémité 12,12' dans le réservoir 4 soit supérieure à la distance entre l'orifice associé 8,8' et l'ouverture 51 de la buse d'aspiration 5.

Le conduit d'évacuation 10,10' s'étend sensiblement de manière oblique dans le réservoir 4. En effet, la première extrémité 11,11' du conduit 10,10', formant jonction étanche avec l'orifice 8,8' associé, est disposée dans la partie haute du réservoir 4.

Afin de permettre l'écoulement par gravité de l'huile dans le conduit d'évacuation 10,10' jusqu'à la deuxième extrémité 12,12', le conduit présente un profil oblique avec une deuxième extrémité 12,12' plus basse dans le réservoir 4 que la première extrémité 11,11'.

Ici, la deuxième extrémité 12,12' est disposée au voisinage du fond 43 du réservoir 4, par exemple à une même hauteur que l'ouverture 51 de la buse d'aspiration 5.

Les extrémités 11,11',12,12' des conduits 10,10' peuvent présenter une forme coudée, de sorte qu'elles définissent une portion sensiblement verticale, ce qui peut favoriser l'écoulement de l'huile en entrée et en sortie du conduit 10, 10', et en particulier pour la deuxième extrémité 12,12', limiter le phénomène de reflux lors d'accélérations transversales du véhicule automobile.

Les conduits 10,10' permettent ainsi d'éviter que l'huile ne remonte dans le carter 3 par les orifices 8,8' lors d'accélérations transversales du véhicule automobile. De cette manière, on s'assure qu'une quantité minimale d'huile est présente dans le réservoir 4 lors de ces accélérations, afin de maintenir l'ouverture 51 de la buse d'aspiration 5 dans l'huile afin d'éviter un désamorçage de la pompe.

## Revendications

1. Dispositif de refroidissement (2) d'une machine électrique (1) destiné à être monté dans un ensemble mobile, ledit dispositif de refroidissement (2) comprenant :
- un carter (3) pour recevoir ladite machine électrique (1),
- un réservoir (4) de liquide diélectrique caloporteur présentant un fond (43) et deux extrémités opposées (41,42), ledit réservoir (4) étant monté à l'aplomb dudit carter (3), tandis que ledit carter (3) présente au moins un orifice d'évacuation (8,8') du liquide diélectrique caloporteur débouchant dans ledit réservoir (4) ;
- des moyens de circulation du liquide diélectrique caloporteur pour venir aspirer le liquide diélectrique caloporteur dans ledit fond (43) dudit réservoir (4) et pour projeter ledit liquide diélectrique caloporteur sur ladite machine électrique (1), tandis que ledit liquide diélectrique caloporteur s'écoule à travers ledit orifice d'évacuation (8, 8') ; ledit orifice d'évacuation (8,8') débouchant à une des deux extrémités opposées (41,42) du réservoir (4) ;
**caractérisé en ce qu'**il comprend en outre un conduit d'évacuation (10,10') du liquide diélectrique s'étendant dans ledit réservoir (4), dudit orifice d'évacuation (8, 8') vers l'autre des deux extrémités opposées (42, 41) du réservoir (4).

2. Dispositif de refroidissement (2) selon la revendication 1, **caractérisé en ce que** les moyens de circulation comprennent une buse d'aspiration (5) disposée sensiblement à équidistance desdites extrémités opposées (41,42) dudit réservoir (4).

3. Dispositif de refroidissement (2) selon la revendication 2, **caractérisé en ce que** ledit conduit d'évacuation (10,10') présente une première extrémité (11,11') et une deuxième extrémité (12,12') éloignées l'une de l'autre d'une distance supérieure à la distance entre l'orifice d'évacuation (8,8') et la buse d'aspiration (5).

4. Dispositif de refroidissement (2) selon la revendication 3, **caractérisé en ce que** ladite première extrémité (11,11') du conduit d'évacuation (10,10') forme une jonction étanche avec ledit orifice (8,8').

5. Dispositif de refroidissement (2) selon la revendication 3 ou 4, **caractérisé en ce que** ladite deuxième extrémité (12,12') du conduit d'évacuation (10,10') est disposée au voisinage de ladite autre des deux extrémités opposées (42,41) du réservoir (4).

6. Dispositif de refroidissement (2) selon l'une quelconque des revendications 3 à 5, **caractérisé en ce que** ledit conduit d'évacuation (10,10') s'étend de manière oblique entre sa première et sa deuxième extrémité (12,12').

7. Dispositif de refroidissement (2) selon l'une quelconque des revendications 1 à 6, **caractérisé en ce que** ledit orifice (8,8') s'étend sensiblement sur toute la longueur de ladite une des deux extrémités opposées (41,42) du réservoir (4).

8. Dispositif de refroidissement (2) selon l'une quelconque des revendications 1 à 7, **caractérisé en ce que** ledit conduit d'évacuation (10,10') est clipsé à ladite paroi du carter (3).

9. Dispositif de refroidissement (2) selon l'une quelconque des revendications 1 à 8, **caractérisé en ce qu'**il comprend deux orifices (8,8') débouchant chacun à une extrémité distincte des deux extrémités opposées (41,42) dudit réservoir (4), le dispositif (2) comprenant deux conduits (10,10') solidaires chacun d'un orifice distinct des deux orifices (8, 8'), lesdits conduits (10, 10') s'étendant chacun depuis ledit orifice distinct (8,8') vers l'extrémité du réservoir (42, 41) à l'opposé dudit orifice distinct (8, 8').

10. Véhicule automobile comprenant un dispositif de refroidissement (2) selon l'une quelconque des revendications 1 à 9.

## Patentansprüche

1. Kühlvorrichtung (2) für eine elektrische Maschine (1) zur Montage in einer beweglichen Baugruppe, wobei die Kühlvorrichtung (2) Folgendes aufweist:
- ein Gehäuse (3) zur Aufnahme der elektrischen Maschine (1),
- einen Behälter (4) mit dielektrischer Wärmeübertragungsflüssigkeit, der einen Boden (43) und zwei gegenüberliegenden Enden (41, 42) aufweist, wobei der Behälter (4) senkrecht zu dem Gehäuse (3) angebracht ist, wohingegen das Gehäuse (3) mindestens eine Auslassöffnung (8, 8') für die dielektrische Wärmeübertragungsflüssigkeit aufweist, die in den Behälter (4) mündet;
- Mittel zum Zirkulieren der dielektrischen Wärmeübertragungsflüssigkeit, um die dielektrische Wärmeübertragungsflüssigkeit in den Boden (43) des Behälters (4) zu saugen und um die dielektrische Wärmeübertragungsflüssigkeit auf die elektrische Maschine (1) zu schleudern, während die dielektrische Wärmeübertragungsflüssigkeit durch die Auslassöffnung (8, 8') fließt; wobei die Auslassöffnung (8, 8') an einem der zwei gegenüberliegenden Enden (41, 42) des Behälters (4) mündet;
**dadurch gekennzeichnet, dass** sie darüber hinaus eine Auslassleitung (10, 10') für die dielektrische Flüssigkeit aufweist, die sich in dem Behälter (4) von der Auslassöffnung (8, 8') in Richtung des anderen der zwei gegenüberliegenden Enden (42, 41) des Behälters (4) erstreckt.

2. Kühlvorrichtung (2) nach Anspruch 1, **dadurch gekennzeichnet, dass** die Mittel zum Zirkulieren eine Ansaugdüse (5) aufweisen, die im Wesentlichen in gleichem Abstand von den gegenüberliegenden Enden (41, 42) des Behälters (4) angeordnet ist.

3. Kühlvorrichtung (2) nach Anspruch 2, **dadurch gekennzeichnet, dass** die Auslassleistung (10, 10') ein erstes Ende (11, 11') und ein zweites Ende (12, 12') aufweist, die einen Abstand voneinander haben, der größer ist als der Abstand zwischen der Auslassöffnung (8, 8') und der Ansaugdüse (5).

4. Kühlvorrichtung (2) nach Anspruch 3, **dadurch gekennzeichnet, dass** das erste Ende (11, 11') der Auslassleitung (10, 10') eine dichte Verbindung mit der Öffnung (8, 8') bildet.

5. Kühlvorrichtung (2) nach Anspruch 3 oder 4, **dadurch gekennzeichnet, dass** das zweite Ende (12, 12') der Auslassleitung (10, 10') in der Nähe des anderen der zwei Enden (42, 41) des Behälters (4) angeordnet ist.

6. Kühlvorrichtung (2) einem der Ansprüche 3 bis 5, **dadurch gekennzeichnet, dass** sich die Auslassleitung (10, 10') schräg zwischen ihrem ersten und ihrem zweiten Ende (12, 12') erstreckt.

7. Kühlvorrichtung (2) einem der Ansprüche 1 bis 6, **dadurch gekennzeichnet, dass** sich die Öffnung (8, 8') im Wesentlichen auf der gesamten Länge des einen der zwei gegenüberliegenden Enden (41, 42) des Behälters (4) erstreckt.

8. Kühlvorrichtung (2) einem der Ansprüche 1 bis 7, **dadurch gekennzeichnet, dass** die Auslassleitung (10, 10') an die Wand des Gehäuses (3) angeklemmt ist.

9. Kühlvorrichtung (2) nach einem der Ansprüche 1 bis 8, **dadurch gekennzeichnet, dass** sie zwei Öffnungen (8, 8') aufweist, die jeweils an einem unterschiedlichen Ende der zwei gegenüberliegenden Enden (41, 42) des Behälters (4) münden, wobei die Vorrichtung (2) zwei Leitungen (10, 10') aufweist, die jeweils fest mit einer unterschiedlichen Öffnung der zwei Öffnungen (8, 8') verbunden sind, wobei die Leitungen (10, 10') sich jeweils von der unterschiedlichen Öffnung (8, 8') bis zum Ende des Behälters (42, 41) auf der gegenüberliegenden Seite der unterschiedlichen Öffnung (8, 8') erstrecken.

10. Kraftfahrzeug, das eine Kühlvorrichtung (2) nach einem der Ansprüche 1 bis 9 aufweist.

## Claims

1. Cooling device (2) for an electrical machine (1), which cooling device is intended to be mounted in a mobile assembly, said cooling device (2) comprising:
- a casing (3) for receiving said electrical machine (1),
- a heat-transfer dielectric liquid reservoir (4) having a bottom (43) and two opposite ends (41, 42), said reservoir (4) being mounted directly below said casing (3), while said casing (3) has at least one discharge hole (8, 8') for the heat-transfer dielectric liquid opening into said reservoir (4);
- means for circulating the heat-transfer dielectric liquid in order to suck the heat-transfer dielectric liquid in said bottom (43) of said reservoir (4) and to spray said heat-transfer dielectric liquid onto said electrical machine (1), while said heat-transfer dielectric liquid flows through said discharge hole (8, 8'); said discharge hole (8, 8') opening at one of the two opposite ends (41, 42) of the reservoir (4);
**characterized in that** it further comprises a discharge conduit (10, 10') for the dielectric liquid extending into said reservoir (4), from said discharge hole (8, 8') toward the other of the two opposite ends (42, 41) of the reservoir (4).

2. Cooling device (2) according to Claim 1, **characterized in that** the circulation means comprise a suction nozzle (5) arranged substantially equidistant from said opposite ends (41, 42) of said reservoir (4).

3. Cooling device (2) according to Claim 2, **characterized in that** said discharge conduit (10, 10') has a first end (11, 11') and a second end (12, 12') spaced apart from one another by a distance greater than the distance between the discharge hole (8, 8') and the suction nozzle (5) .

4. Cooling device (2) according to Claim 3, **characterized in that** said first end (11, 11') of the discharge conduit (10, 10') forms a sealed junction with said hole (8, 8').

5. Cooling device (2) according to Claim 3 or 4, **characterized in that** said second end (12, 12') of the discharge conduit (10, 10') is arranged in the vicinity of said other of the two opposite ends (42, 41) of the reservoir (4).

6. Cooling device (2) according to any one of Claims 3 to 5, **characterized in that** said discharge conduit (10, 10') extends diagonally between the first and the second end (12, 12') thereof.

7. Cooling device (2) according to any one of Claims 1 to 6, **characterized in that** said hole (8, 8') extends substantially over the entire length of the said one of the two opposite ends (41, 42) of the reservoir (4).

8. Cooling device (2) according to any one of Claims 1 to 7, **characterized in that** said discharge conduit (10, 10') is clipped to said wall of the casing (3).

9. Cooling device (2) according to any one of Claims 1-8, **characterized in that** it comprises two holes (8, 8') each opening at a separate end of the two opposite ends (41, 42) of said reservoir (4), the device (2) comprising two conduits (10, 10') each rigidly connected to a separate hole of the two holes (8, 8'), said conduits (10, 10') each extending from said separate hole (8, 8') towards the end of the reservoir (42, 41) opposite said separate hole (8, 8').

10. Motor vehicle comprising a cooling device (2) according to any one of Claims 1 to 9.
